# EUROPÄISCHE PATENTSCHRIFT

(11) **EP 3 147 949 B1**
(45) Veröffentlichungstag und Bekanntmachung des Hinweises auf die Patenterteilung: **06.11.2024**
(21) Anmeldenummer: 16187998.6
(22) Anmeldetag: 09.09.2016
(51) Int. Cl.: H10K 59/19, H10K 77/10

(54) **BIEGUNG EINER ORGANISCHEN LEUCHTDIODENVORRICHTUNG**
BENDING OF AN ORGANIC LIGHT-EMITTING DIODE
CINTRAGE D'UN DISPOSITIF DE DIODES LUMINEUSES ORGANIQUES

(30) Priorität: 24.09.2015 DE 102015012279
(43) Veröffentlichungstag der Anmeldung: 29.03.2017
(73) Patentinhaber: AUDI AG, 85045 Ingolstadt (DE)
(72) Erfinder: Lendle, Reiner, 74855 Haßmersheim (DE); Horn, Michael, 85049 Ingolstadt (DE); Thomas, Werner, 85055 Ingolstadt (DE); Rabenau, Philipp, 85134 Stammham (DE)
(74) Vertreter: Hofstetter, Schurack & Partner

(56) Entgegenhaltungen:
- EP-A1- 2 346 108
- WO-A1-2015/001040
- JP-A- 2008 107 440
- US-A1- 2012 286 649
- US-A1- 2015 029 683
- US-A1- 2015 233 557

## Beschreibung

Die vorliegende Erfindung betrifft eine organische Leuchtdiodenvorrichtung mit einem biegbaren Substrat, einer organischen Leuchtdiodenschichtanordnung, die eine organische Emitterschicht aufweist, die auf dem biegbaren Substrat ausgebildet ist und die einen ersten Leuchtbereich aufweist, und einer Ansteuereinrichtung zum Ansteuern des ersten Leuchtbereichs zum Leuchten, wobei das Substrat einen Biegebereich aufweist, in dem das Substrat gebogen ist.

Organische Leuchtdioden sind Dünnschichtbauelemente aus organischen, halbleitenden Materialien. Der Vorteil solcher Dünnschichtbauelemente ist, dass sie auf einen Träger aufgebracht werden können und so ohne Weiteres die dreidimensionale Struktur dieses Trägers annehmen können. Darüber hinaus können sie auch auf flexible Träger aufgebracht werden und aufgrund ihres Dünnschichtaufbaus dann mit dem Träger in gewissen Grenzen gebogen werden.

Bislang werden organische Leuchtdioden (OLEDs) für automotive Anwendungen vorwiegend zweidimensional auf Basis eines Glassubstrats gefertigt. Eine entsprechende OLED besitzt dann die zweidimensionale Struktur des Glassubstrats.

Demgegenüber bestehen deutlich mehr räumliche Gestaltungsmöglichkeiten, wenn die organische Leuchtdiode als organische Leuchtdiodenschichtanordnung auf einen flexiblen Träger aufgebracht wird. Beispielsweise handelt es sich bei einem solchen flexiblen Träger um eine biegbare Kunststofffolie. Eine solche Kunststofffolie lässt sich beispielsweise um einen Zylinder wickeln oder auf einen wellenförmigen Untergrund aufbringen. Die Folie ist also in der Regel nur um eine oder mehrere parallele Biegeachsen biegbar. Das Umspannen einer Kugel mit der biegbaren Kunststofffolie ist beispielsweise nicht ohne entsprechende Einschnitte der Folie möglich.

Darüber hinaus werden die Gestaltungs- bzw. Designmöglichkeiten mit flexiblen OLEDs als 2,5D- (gebogener 2D-Körper) bzw. 3D-Designkörper derzeit noch durch die großen zulässigen Biegeradien von mehr als 10 mm stark eingeschränkt. Eine weitere große technologische Herausforderung ergibt sich ferner durch die zusätzliche Belastung der funktionalen Strukturen der OLED durch die Biegung, was eine Verkürzung der OLED-Lebensdauer zur Folge hat. Eine Formgebung durch Torsion stellt hierbei die größte mechanische Belastung für das Bauteil dar, was eine Umsetzung in der Fahrzeugbeleuchtung derzeit noch ausschließt.

Nachteilig an der Verwendung von festen Glassubstraten als Träger ist, dass solche 2D-Glassubstrate eine räumliche Gestaltung der Lichtquelle unmöglich machen. Auch der Einsatz flexibler OLEDs als 2,5D-Element mit Biegeradien von mehr als 10 mm schränkt, wie erwähnt, die Designfreiheit ein. Da zudem eine Torsion der OLED nicht möglich ist, werden viele einzelne OLED-Bauteile benötigt, um anspruchsvolle 3D-Designs zu realisieren. Die Komplexität in der Gestaltung erfordert einen hohen technischen Aufwand durch den Einsatz vieler verschiedener einzelner OLEDs im Herstellungs- und Montageprozess.

Aus der Druckschrift WO 2015/001040 A1 ist eine Leuchtdiode mit einer organischen Schichtfolge bekannt. Die Leuchtdiode umfasst mindestens einen Verformbereich, der sich an einem Stabilisierungsbereich befindet. Die organische Schichtfolge ist an dem Verformbereich und/oder an dem Stabilisierungsbereich aufgebracht.

Die Druckschrift US 2015/0233557 A1 beschreibt eine Lichtemissionsvorrichtung. Sie besitzt einen Verbindungsabschnitt und eine Vielzahl an voneinander getrennten Lichtemissionseinheiten. Der Verbindungsbereich kann mit einem kleineren Krümmungsradius gebogen werden als die Lichtemissionseinheiten.

Die Druckschrift US 2012/0286649 A1 offenbart eine dreidimensionale OLED-Lampe. Die OLEDs sind in einer dreidimensionalen Konfiguration selbsttragend. Sie können sprialförmig aufgewickelt werden.

Ferner zeigt die Druckschrift EP 2 346 108 A1 ein elektrooptisches Folienprodukt. Es besitzt eine Basissubstratschicht aus organischer Substanz und hat eine konvexe und eine konkave Seite. Auf der konvexen Seite der Basissubstratschicht befindet sich eine zusätzliche Schicht. Das Folienprodukt besitzt außerdem eine elektrooptische Struktur.

Die US 2015/029683 A1 beschreibt eine Displayvorrichtung mit einem flexiblen Substrat, ersten Pixeln und zweiten Pixeln, wobei das flexible Substrat einen ersten, wenigstens teilweise gebogenen Bereich um eine Achse, und einen zweiten nicht gebogenen Bereich aufweist. Die ersten Pixel sind dabei im ersten Bereich angeordnet. Die zweiten Pixel sind in dem nicht gebogenen Bereich angeordnet. Dabei sind die ersten Pixel in einer ersten Richtung schmaler als die Breite bezüglich der zweiten Pixel in die erste Richtung.

Ferner zeigt die JP 2008 107440 A eine Anzeigevorrichtung, welche ein Anzeigeelement mit einer Anzeigeschicht, die zwischen einer transparenten Oberflächenelektrodenschicht und einer Rückelektrodenschicht liegt, einen transparenten Oberflächenschutzfilm, der auf der oberen Fläche des Anzeigeelements angeordnet ist, und einen rückseitigen Schutzfilm, der auf der unteren Fläche des Anzeigeelements angeordnet ist, umfasst. Eine große Anzahl von Faltnuten sind parallel zueinander in gleichen Abständen entlang der Biegerichtung des Anzeigeelements auf der unteren Fläche der Rückseite angeordnet.

Die Aufgabe der vorliegenden Erfindung besteht somit darin, eine organische Leuchtdiodenvorrichtung bereitzustellen, mit der räumliche Leuchtkörper leichter realisierbar sind.

Erfindungsgemäß wird diese Aufgabe gelöst durch eine organische Leuchtdiodenvorrichtung nach Anspruch 1.

Die organische Leuchtdiodenvorrichtung besitzt demnach eine biegbare Trägerschicht, die beispielsweise als Kunststofffolie realisiert sein kann. Insbesondere kann es sich um eine transparente Kunststofffolie handeln.

Ferner weist die organische Leuchtdiodenvorrichtung eine organische Leuchtdiodenschichtanordnung auf, die eine organische Emitterschicht besitzt. Die Leuchterscheinung ergibt sich aus einer Rekombination der Ladungsträger in der Emitterschicht.

Darüber hinaus ist die Leuchtdiodenschichtanordnung auf der biegbaren Trägerschicht ausgebildet. Beispielsweise kann sie durch geeignete Abscheideprozesse (Aufdampfen oder dergleichen) ausgebildet sein. Dabei wird ein erster und optional ein zweiter ebener Leuchtbereich ausgebildet, in denen die Trägerschicht bzw. die Leuchtdiodenschichtanordnung nicht oder nur unwesentlich gebogen ist.

Die Trägerschicht der organischen Leuchtdiodenvorrichtung besitzt einen Biegebereich, in dem die Trägerschicht gebogen ist. Gegebenenfalls nehmen die beiden ebenen oder leicht gebogenen Leuchtbereiche, die durch den Biegebereich miteinander verbunden sind, dadurch zueinander einen definierten Winkel ein.

Die organische Emitterschicht ist zumindest in einem Teil des ersten Biegebereichs nicht ausgebildet .

Da die organische Emitterschicht sehr empfindlich gegenüber mechanischen Biegebeanspruchungen ist, kann somit vermieden werden, dass durch übermäßiges Biegen des Biegebereichs eine Beschädigung dieser organischen Schicht erfolgt bzw. ein durch Biegung gefährdeter Bereich für eine Leuchtfunktion benutzt wird.

In einer Ausführungsform die keinen Teil der beanspruchten Erfindung bildet, erstreckt sich die gesamte Leuchtdiodenschichtanordnung nicht in dem ersten Biegebereich. Dies bedeutet, dass in dem ersten Biegebereich nicht nur die organische Emitterschicht, sondern auch die anderen Schichten der organischen Leuchtdiodenschichtanordnung fehlen. Mit anderen Worten ist die organische Leuchtdiodenschichtanordnung in dem Biegebereich unterbrochen. Damit kann der Biegebereich starken Biegebeanspruchungen unterzogen werden.

Gemäß einer weiteren bevorzugten Ausführungsform ist eine Biegeachse definiert, um die der gesamte erste Biegebereich gebogen ist. Dies bedeutet, dass der erste Biegebereich die Form eines Abschnitts eines Zylindermantels annimmt. Hierdurch können die beiden Leuchtbereiche ohne eine Verdrehung zueinander gekippt werden.

Erfindungsgemäß kann die Trägerschicht in dem ersten Biegebereich durch eine Torsion gebogen sein. Da die Emitterschicht in dem Biegebereich fehlt, besteht durch die Torsion keine Gefahr der Beschädigung des organischen Schichtstapels. Folglich bestehen durch die Torsion wesentlich mehr räumliche Gestaltungsmöglichkeiten der organischen Leuchtdiodenvorrichtung.

Ferner kann vorgesehen sein, dass sich an den zweiten ebenen Leuchtbereich ein zweiter Biegebereich anschließt und daran ein dritter Leuchtbereich. Folglich ergäbe sich ein einziges Bauteil mit fünf voneinander getrennten Bereichen, nämlich drei Leuchtbereichen und zwei Biegebereichen. Die Herstellung und Montage eines solchen Bauteils ist entsprechend einfacher als bei mehreren Einzelbauteilen.

Falls also zwei verschiedene Biegebereiche mit zwei verschiedenen Biegeachsen vorgesehen sind, müssen diese Biegeachsen nicht parallel zueinander verlaufen, d.h. sie schneiden sich in einem Punkt. Durch die nicht parallelen Biegeachsen können Körper realisiert werden, die von der reinen Wellenform abweichen.

Die organische Leuchtdiodenvorrichtung ist natürlich nicht darauf beschränkt, dass sie nur drei Leuchtbereiche und zwei Biegebereiche aufweist. Vielmehr kann sie auch weitere Biege- und Leuchtbereiche besitzen. So können beispielsweise Biege- und Leuchtbereiche abwechselnd zu einer beliebig langen Kette hintereinander angeordnet werden.

Bei mehreren Biegeachsen können diese einen von 0 verschiedenen Winkel zueinander einnehmen. Ein entsprechender spitzer Winkel α kann im Bereich von 0° < a ≤ 90° liegen. Bei Ausgestaltungen liegt der Winkel α bei 90° oder beispielsweise 45°.

Ein Biegeradius innerhalb des ersten Biegebereichs muss entlang einer Biegelinie nicht konstant sein, sondern kann variieren. Beispielsweise kann ein weicher Anlauf und Auslauf vorgesehen sein, dazwischen ein kleinerer Biegeradius.

Ein Leuchtbereich kann homogen als gesamte Leuchteinheit angesteuert werden. Darüber hinaus kann ein Leuchtbereich aber auch in Unterleuchtbereiche unterteilt sein. Jeder dieser Unterleuchtbereiche kann mit einer separaten Stromstärke bzw. Helligkeit angesteuert werden. Gegebenenfalls besitzen die Unterleuchtbereiche auch verschiedene Farben.

Die zwei oder zwei der mehreren Leuchtbereiche können voneinander unabhängig von einer Ansteuereinrichtung angesteuert sein. Es müssen also nicht sämtliche Leuchtbereiche der organischen Leuchtdiodenvorrichtung einheitlich angesteuert werden, sondern sie können vielmehr einzeln oder in Gruppen angesteuert werden. Dadurch erhöht sich der Einsatzbereich der organischen Leuchtdiodenvorrichtung.

Prinzipiell können zumindest zwei der Leuchtbereiche auch in Serie oder parallel von der Ansteuereinrichtung angesteuert sein. Dies bedeutet, dass diese beiden Leuchtbereiche dann miteinander und gegebenenfalls auch gleich hell leuchten, wenn sie zusammen angesteuert werden. Diese zusammengeschalteten Leuchtbereiche müssen nicht aneinandergrenzen, sondern vielmehr kann zwischen den Leuchtbereichen neben dem Biegebereich auch ein weiterer Leuchtbereich angeordnet sein.

Weiterhin können mindestens zwei der Leuchtbereiche voneinander unterschiedliche Leuchtfarben besitzen. So kann beispielsweise ein erster Leuchtbereich zum Leuchten in roter Farbe und ein zweiter Leuchtbereich zum Leuchten in gelber Farbe angeregt bzw. angesteuert werden. Gegebenenfalls können auch die einzelnen Leuchtbereiche zu unterschiedlichen Helligkeiten angeregt werden, so dass beispielsweise ein erster Bereich heller leuchtet als ein zweiter Bereich.

Der erste Leuchtbereich kann außerdem mehrere Emitterschichten übereinander aufweisen, die jeweils entweder die gleiche Farbe oder auch unterschiedliche Farben abstrahlen. Diese Schichten können zusammen angesteuert werden, oder auch einzeln, um z.B. unterschiedliche Farben im gleichen Bereich darzustellen.

In einer bevorzugten Ausgestaltung verlaufen sowohl eine erste Grenzlinie zwischen dem ersten Leuchtbereich und dem ersten Biegebereich als auch eine zweite Grenzlinie zwischen dem zweiten Leuchtbereich und dem ersten Biegebereich parallel zur Biegeachse. Dies hat den Vorteil, dass der Biegebereich ein Abschnitt eines Zylindermantels ist. Entsprechend einer alternativen Ausführungsform können die jeweiligen Grenzlinien auch einen Winkel zu der korrespondierenden Biegeachse aufweisen, so dass der angrenzende Leuchtbereich gegenüber der Biegeachse entsprechend gedreht ist.

Die biegbare Trägerschicht kann auf vielfältigen, räumlich geformten Gebilden oder Haltern beispielsweise eines Kraftfahrzeugs aufgebracht werden. Damit können diese Gebilde oder Halter entsprechende Träger für Leuchtmittel werden.

Bei einer besonders bevorzugten Anwendung wird ein Kraftfahrzeug mit einer derartigen organischen Leuchtdiodenvorrichtung, wie sie oben beschrieben ist, ausgestattet. Hierbei kann beispielsweise ein Schlusslicht, ein Bremslicht und ein Blinklicht mit dieser organischen Leuchtdiodenvorrichtung als einzelnes Bauelement realisiert sein. Auf diese Weise kann beispielsweise die Rückleuchte eines Kraftfahrzeugs, welche die genannten Lichter aufweist, mit einer einzigen Leuchtdiodenvorrichtung ausgeführt sein. Durch die dreidimensionale Gestaltung können dann nicht nur die gesetzlichen Vorgaben, was Helligkeit und Winkelverteilung betrifft, eingehalten werden, sondern es werden auch besondere Designmöglichkeiten eröffnet.

Die vorliegende Erfindung wird nun anhand der beigefügten Zeichnungen näher erläutert, in denen zeigen:
- Fig. 1: eine Draufsicht auf eine ungebogene organische Leuchtdiodenvorrichtung mit mehreren Leucht- und Biegebereichen;
- Fig. 2: eine organische Leuchtdiodenvorrichtung mit besonderer geometrischer Gestaltung und eingezeichneten Leuchtfunktionsabschnitten; und
- Fig. 3: ein Kraftfahrzeug, bei dem beispielsweise eine Rückleuchte mit einer erfindungsgemäßen organischen Leuchtdiodenvorrichtung ausgestattet ist.

Die nachfolgend näher geschilderten Ausführungsbeispiele stellen bevorzugte Ausführungsformen der vorliegenden Erfindung dar. Dabei ist zu beachten, dass die einzelnen Merkmale nicht nur in den geschilderten Merkmalskombinationen, sondern auch in Alleinstellung oder in anderen Kombinationen realisierbar sind.

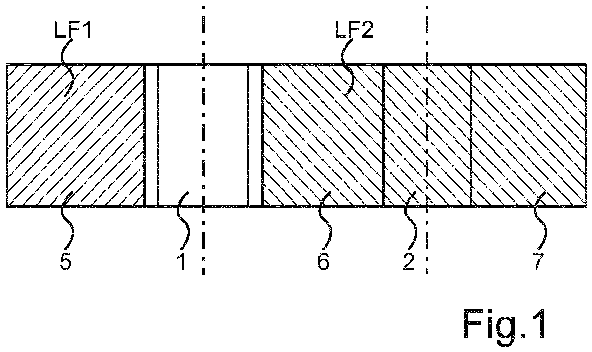

In dem Beispiel von Fig. 1 ist eine organische Leuchtdiodenvorrichtung mit einer linearen Kontur in einer Draufsicht dargestellt. Als Träger wird eine biegbare Trägerschicht verwendet, die beispielsweise eine transparente Kunststofffolie sein kann. Die biegbare Trägerschicht ist mit einer organischen Leuchtdiodenschichtanordnung zumindest teilweise beschichtet. Eine solche organische Leuchtdiodenschichtanordnung weist typischerweise mehrere Schichten auf, von denen eine eine Kathode und eine andere eine Anode darstellt. Zwischen der Anodenschicht und der Kathodenschicht befindet sich beispielsweise eine Lochleitungsschicht und eine Emitter- bzw. Rekombinationsschicht. Eine solche Schichtanordnung ist beispielsweise wenige Zehntel Millimeter dick. Sie beeinträchtigt daher die Biegbarkeit der Trägerschicht nur geringfügig. Grundsätzlich ist jedoch die Emitterschicht in einem Biegebereich beim Biegen mit einem zu kleinen Biegeradius gefährdet.

In dem Bild von Fig. 1 ist die organische Leuchtdiodenschichtanordnung in Draufsicht dargestellt, weshalb die einzelnen Schichten nicht zu erkennen sind. Je nach Ausführungsform kann die unter der organischen Leuchtdiodenschichtanordnung liegende, biegbare Trägerschicht bereichsweise in der Draufsicht zu erkennen sein oder nicht.

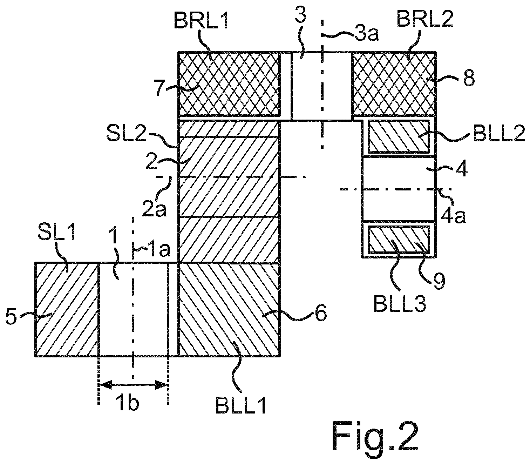

Die spezielle Form der in Fig. 1 abgewickelten bzw. noch nicht gebogenen 2D-Leuchtdiodenvorrichtung ergibt sich aus dem 3D-Körper, der nach dem Biegen erhalten werden soll. Mit dem linearen 2D-Gebilde kann im gebogenen Zustand beispielsweise eine Art Dreieckszylinder oder ein offener Viereckzylinder realisiert werden. Demgegenüber kann mit dem etwas komplexeren 2D-Gebilde von Fig. 2 beispielsweise nach dem Biegen eine Art Viertelkugel erhalten werden. Eine so geformte Leuchtvorrichtung kann beispielsweise in vier von sechs Raumrichtungen Licht abstrahlen.

In dem einfachen Beispiel von Fig. 1 weist die organische Leuchtdiodenvorrichtung fünf verschiedene physische Bereiche auf. In einer Reihenfolge von links nach rechts in der Zeichnung schließen ein erster Leuchtbereich 5, ein erster Biegebereich 1, ein zweiter Leuchtbereich 6, ein zweiter Biegebereich 2 und ein dritter Leuchtbereich 7 seriell aneinander an. Die konkrete Geometrie der einzelnen Bereiche ist für das Prinzip der vorliegenden Erfindung nicht von Belang. Wesentlich ist hier, dass ein Biegebereich, hier der erste Biegebereich 1, keine vollständige OLED besitzt. Insbesondere befindet sich in dem ersten Biegebereich 1 hier keine sensible Organikschicht. Eine solche empfindliche organische Schicht kann also durch starkes Biegen, Knicken oder durch Torsion nicht beschädigt werden. Gegebenenfalls ist der Biegebereich 1 ganz oder teilweise mit einer Anodenschicht und/oder einer Kathodenschicht und/oder Ladungsträgerleiterschicht beschichtet. Diese Schichten sind in der Regel jedoch weniger empfindlich gegenüber mechanischen Beanspruchungen.

In dem Beispiel von Fig. 1 ist der zweite Biegebereich 2 wie auch die Leuchtbereiche 5, 6 und 7 mit einer Leuchtdiodenschichtanordnung beschichtet, so dass auch der zweite Biegebereich 2 zum Leuchten angeregt werden kann. Konkret ist innerhalb des Leuchtbereichs 5 eine Leuchtfläche LF1 vorgesehen. Der Leuchtbereich 5 weist hier also einen Rand zu dem Biegebereich 1 auf, der entweder eine Emissionsschicht aufweist und nicht zum Leuchten angesteuert ist, oder aber auch keine Emissionsschicht aufweist. Dieser Rand ist jedoch rein optional. Auch auf der rechten Seite hin zum zweiten Leuchtbereich 6 ist im vorliegenden Beispiel ein solcher Rand vorgesehen.

Der zweite Leuchtbereich 6, der zweite Biegebereich 2 und der dritte Leuchtbereich 7 bilden zusammen eine zweite Leuchtfläche LF2. Der zweite Biegebereich 2 befindet sich also innerhalb der Leuchtfläche LF2. Daher ist in dem zweiten Biegebereich 2 der mögliche Biegeradius aufgrund des komplexen Aufbaus der OLED stark eingeschränkt. Demgegenüber befindet sich der erste Biegebereich 1 erfindungsgemäß in einem nicht leuchtenden Bereich der OLED, d.h. zumindest die Emissionsschicht der OLED ist hier nicht ausgebildet. Hierdurch sind im ersten Biegebereich 1 wesentlich kleinere Biegeradien als in dem zweiten Biegebereich 2 mit der kompletten Leuchtdiodenschichtanordnung der OLED möglich. Gegebenenfalls sind in dem ersten Biegebereich 1 sogar Torsionen und Knickungen möglich.

Fig. 2 zeigt nun eine mehrfach abgewinkelte zweidimensionale Struktur einer organischen Leuchtdiodenvorrichtung vor dem Biegen. Auch wenn die Geometrie etwas anders ist als in dem Beispiel von Fig. 1, wurde für Fig. 2 die Nummerierung der einzelnen Funktionsbereiche soweit wie möglich übernommen. Konkret besitzt die organische Leuchtdiodenvorrichtung von Fig. 2 einen ersten Biegebereich 1, einen zweiten Biegebereich 2, einen dritten Biegebereich 3 und einen vierten Biegebereich 4. Der erste Biegebereich 1 liegt zwischen einem ersten Leuchtbereich 5 und einem zweiten Leuchtbereich 6. Der zweite Biegebereich 2 liegt zwischen dem zweiten Leuchtbereich 6 und einem dritten Leuchtbereich 7. Der dritte Biegebereich 3 liegt zwischen dem dritten Leuchtbereich 7 und einem vierten Leuchtbereich 8. Der vierte Biegebereich 4 schließlich liegt zwischen dem vierten Leuchtbereich 8 und einem fünften Leuchtbereich 9. Die Anzahl der Leuchtbereiche beträgt mindestens zwei und ist nach oben nicht begrenzt. Die Anzahl der Biegebereiche beträgt mindestens eins und ist ebenfalls nach oben nicht begrenzt.

Im vorliegenden Beispiel sind die Biegebereiche 1 bis 4 rechteckförmig ausgestaltet. An gegenüberliegenden Seiten schließt jeweils ein Leuchtbereich an. Jeder Biegebereich zeichnet sich dadurch aus, dass er im endgültigen Zustand gebogen ist, während jeder Leuchtbereich im Wesentlichen eben oder leicht gebogen ist. Den Übergang zwischen einem Biegebereich und einem Leuchtbereich bildet eine jeweilige Grenzlinie. Alternativ können die Biegebereiche auch dreiecksförmig oder trapezförmig ausgebildet sein.

Jeder Biegebereich 1 bis 4 besitzt hier eine jeweilige Biegeachse 1a, 2a, 3a und 4a. Diese jeweilige Biegeachse liegt nicht in der Ebene der abgewickelten Leuchtdiodenvorrichtung, sondern darüber oder darunter, je nachdem, in welche Richtung gebogen wird. Der Abstand der jeweiligen Biegeachse zur Ebene der Leuchtdiodenvorrichtung wird durch den jeweiligen, gegebenenfalls veränderlichen Biegeradius bestimmt. Die Breite 1b beispielsweise des ersten Biegebereichs 1 kann wie derjenige der anderen Biegebereiche bedarfsmäßig gewählt werden.

Im Fall von Fig. 2 besitzt die zweidimensionale, abgewinkelte Leuchtdiodenvorrichtung die Gestalt von zwei aneinandergefügten "L". Das erste "L" bilden die Bereiche 5, 1, 6, 2 und 7, während das zweite "L" die Bereiche (7), 3, 8, 4 und 9 bilden. Dies bedeutet, dass die Leuchtbereiche 5, 6, 7, 8 und 9 hier ebenfalls rechteckförmig ausgestaltet sind, sie können aber auch eine andere Form besitzen. Die Biegeachsen der Biegebereiche verlaufen jeweils senkrecht zu den jeweiligen Schenkeln der beiden "L". Jeder Biegebereich 1, 2, 3, 4 besitzt zwei gegenüberliegende Seiten, die die Grenze zu jeweils benachbarten Leuchtbereichen bilden. Die Grenzlinien eines Biegebereichs zu den benachbarten Leuchtbereichen müssen nicht parallel sein und können aufeinander zulaufen, wenn der Biegebereich beispielsweise dreiecksförmig oder trapezförmig gebildet ist. Ein Biegebereich kann aber auch beispielsweise die Form eine Parallelogramms annehmen.

Die Grenzlinien zwischen Biegebereichen und Leuchtbereichen verlaufen hier parallel zu der jeweiligen Achse des Biegebereichs. Auch dies ist nur optional. Die Biegebereiche 1 bis 4 berühren sich im vorliegenden Beispiel nicht. Auf diese Weise lassen sich beispielsweise Torsionen der Biege- und Leuchtbereiche vermeiden. So bleibt beispielsweise der Leuchtbereich 8 vollkommen eben, auch wenn der dritte Biegebereich 3 um die Biegeachse 3a und der vierte Biegebereich 4 um die Biegeachse 4a gebogen wird. Insgesamt ergibt sich durch die Form der OLED und die Lage der Biegebereiche ein 3D-Körper, obwohl die OLED in jedem Biegebereich nur entlang einer Achse gebogen wird.

Fig. 2 zeigt ferner eine konkrete Zuweisung der Leuchtfunktionalität zu den einzelnen Bereichen der Leuchtdiodenvorrichtung.

Der erste Leuchtbereich 5 besitzt hierbei beispielsweise die Funktionalität SL1, nämlich die eines ersten Schlusslichts. Ein Teil des zweiten Leuchtbereichs 6 besitzt die Funktionalität BLL1, nämlich die eines ersten Blinklichts. Ein anderer Teil des zweiten Leuchtbereichs 6 besitzt die Funktionalität SL2, nämlich die eines Teils eines zweiten Schlusslichts. Der zweite Biegebereich und ein Teil des dritten Leuchtbereichs 7 besitzen ebenfalls die Funktionalität SL2. Dies bedeutet nicht nur, dass ein Biegebereich grundsätzlich auch die Leuchtfunktionalität wie ein Leuchtbereich übernehmen kann, sondern dass auch die Leuchtfunktionalität nicht an die physischen Grenzen der einzelnen Leucht- und Biegebereiche gekoppelt sein muss.

Außer der Funktionalität SL2 übernimmt der dritte Leuchtbereich 7 auch die Funktionalität BRL1 eines ersten Bremslichts. Der vierte Leuchtbereich 8 übernimmt die Funktionalitäten BRL2 und BLL2 für ein zweites Bremslicht und ein zweites Blinklicht. Der fünfte Leuchtbereich 9 besitzt die Funktionalität BLL3 eines dritten Blinklichts.

Die Biegebereiche 1, 3 und 4 besitzen hier erfindungsgemäß keine OLED-Funktion. Dazu wurde in diesen Bereichen auf die Emissionsschicht und gegebenenfalls zumindest Teile der weiteren Schichten der organischen Leuchtdiodenschichtanordnung verzichtet. Alternativ wird auf keine der Schichten verzichtet, aber der Bereich der starken Biegung wird nicht elektrisch angesteuert. Somit ist es unrelevant, wenn hier eine Beschädigung entsteht. Damit lässt sich das in Fig. 2 dargestellte Gebilde einer 2D-Leuchtdiodenvorrichtung in den Biegebereichen 1, 3 und 4 stärker biegen bzw. verdrehen als in dem Biegebereich 2, der die volle OLED-Funktionalität, d.h. die Leuchtfunktion, besitzt. Hierbei sei darauf hingewiesen, dass die Biegebereiche nicht zwangsläufig Biegeachsen wie in dem Beispiel von Fig. 2 aufweisen müssen.

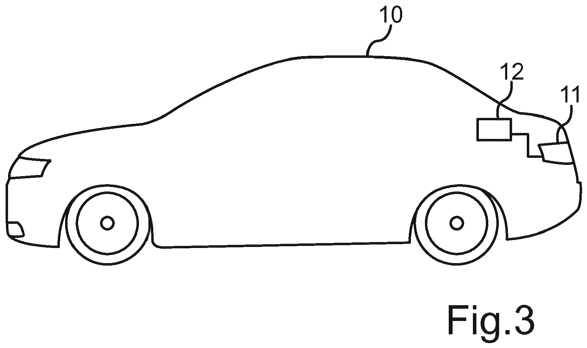

Die einzelnen Bereiche der organischen Leuchtdiodenvorrichtung werden durch eine in Fig. 3 nicht aber in Fig. 2 dargestellte Ansteuervorrichtung 12 angesteuert. In einer bevorzugten Ausgestaltung lassen sich die einzelnen funktionalen Bereiche unabhängig von den physischen Bereichen 1 bis 9 ansteuern bzw. adressieren.

Das Ausführungsbeispiel von Fig. 2 zeigt ferner, dass eine organische Leuchtdiodenvorrichtung als einzelnes Bauelement durchaus unterschiedliche Emitterschichten aufweisen kann, so dass unterschiedliche Leuchtfarben in verschiedenen funktionellen Bereichen realisiert werden können. Gegebenenfalls kann auch die Option bestehen, die verschiedenen Bereiche mit unterschiedlichen Stromstärken anzusteuern, so dass die Helligkeit entsprechend variiert werden kann.

Fig. 3 gibt schematisch ein Kraftfahrzeug 10 wieder, dessen Rückleuchte 11 mit einer oben dargestellten organischen Leuchtdiodenvorrichtung ausgestattet ist. Eine solche Rückleuchte 11 besitzt typischerweise ein Schlusslicht, ein Bremslicht und ein Blinklicht. Nach gesetzlichen Vorgaben müssen die einzelnen Lichter nicht nur eine gewisse Helligkeit, sondern auch eine bestimmte Winkelverteilung besitzen. Dies lässt sich hier einfach durch eine einzige organische Leuchtdiodenvorrichtung realisieren. Zur Erzielung einer gewissen Helligkeit wird eine geeignete Fläche der Leuchtdiodenvorrichtung mit einem entsprechenden Strom angesteuert. Die Winkelverteilung lässt sich durch entsprechendes Biegen von Abschnitten der Leuchtdiodenvorrichtung erreichen, wobei gegebenenfalls mehrere Leuchtbereiche in unterschiedliche Richtungen weisen, um z. B. eine gemeinsame Schlusslichtfunktionalität (SL1 und SL2) zu erreichen. Die entsprechende Ansteuereinrichtung 12 ist in das Kraftfahrzeug 10 integriert.

Somit ist die Umsetzung eines 3D-OLED-Moduls aus einer einzelnen OLED möglich, die aus mehreren Biegelinien auf dem Bauteil sowie die individuellen Bauteilmaße und -formen besteht. Die daraus hervorgehenden einzelnen Teilflächen können zudem durch gezielte Segmentierung der OLED unabhängig voneinander angesteuert werden und somit verschiedene Lichtfunktionen realisieren. An einem Beispiel wurde gezeigt, dass in der Heckbeleuchtung eine Teilfläche die Schlusslichtfunktion erfüllt, während eine weitere Teilfläche das Bremslicht darstellt. Alternativ können die Flächen in Doppelfunktion sowohl als Schlusslicht als auch als Bremslicht etc. fungieren. Es ergeben sich hierbei beliebige Kombinationsmöglichkeiten in der Schaltung der einzelnen Teilflächen und ihrem Zusammenspiel. Hiermit ergeben sich völlig neue Design- und Gestaltungsmöglichkeiten im Leuchtenbau.

Gemäß der vorliegenden Erfindung befinden sich auf der OLED sowohl leuchtende als auch nicht leuchtende Bereiche. Eine oder mehrere Biegungen der OLED befinden sich in einem nicht leuchtenden Bereich. Dieser Bereich ist weniger komplex aufgebaut und lässt eine größere Biegung (kleineren Biegeradius) als in den leuchtenden Bereichen zu. Je nach Ausführung ist auch denkbar, diese Bereiche durch Torsion zu belasten.

Die geringeren Biegeradien ermöglichen völlig neue Designs sowie Optimierungen des Packages. Weiterhin können sich unterschiedliche leuchtende Bereiche auf ein und derselben OLED befinden, was neben Design- zu Kostenvorteilen führt. Der Entfall der empfindlichen Organik an Stellen erhöhter mechanischer Belastung, der auch die Reduzierung der Biegeradien ohne Schädigung der emittierenden Schichten ermöglicht, schränkt außerdem die Lebensdauer des Bauteils nicht weiter ein.

## Patentansprüche

1. Organische Leuchtdiodenvorrichtung mit
- einem biegbaren Substrat,
- einer organischen Leuchtdiodenschichtanordnung, die eine organische Emitterschicht aufweist, die auf dem biegbaren Substrat ausgebildet ist und die einen ersten Leuchtbereich (5, 6) aufweist, und
- einer Ansteuereinrichtung zum Ansteuern des ersten Leuchtbereichs (5) zum Leuchten, wobei
- das Substrat einen ersten Biegebereich (1) aufweist, in dem das Substrat gebogen ist,
**dadurch gekennzeichnet, dass**
- der erste Biegebereich (1) nicht zum Leuchten ansteuerbar durch die Ansteuereinrichtung ist,
- zumindest in einem Teil des ersten Biegebereichs (1) die organische Emitterschicht nicht ausgebildet ist, aber eine Anodenschicht und/oder eine Kathodenschicht und/oder eine Ladungsträgerleiterschicht aufweist,
und
- das Substrat in dem ersten Biegebereich (1) durch eine Torsion gebogen ist, oder
- sich ein Biegeradius innerhalb des ersten Biegebereichs entlang einer Biegelinie ändert.

2. Organische Leuchtdiodenvorrichtung nach Anspruch 1, wobei eine Biegeachse (1a) definiert ist, um die der gesamte erste Biegebereich (1) gebogen ist.

3. Organische Leuchtdiodenvorrichtung nach einem der vorhergehenden Ansprüche, wobei die organische Leuchtdiodenschichtanordnung einen zweiten Leuchtbereich (6) aufweist, und der erste Biegebereich (1) den ersten Leuchtbereich (5) mit dem zweiten Leuchtbereich (6) verbindet, und wobei sich optional an den zweiten Leuchtbereich (6) ein zweiter Biegebereich (2) anschließt und daran ein dritter Leuchtbereich (7).

4. Organische Leuchtdiodenvorrichtung nach einem der vorhergehenden Ansprüche, wobei der erste und der zweite Leuchtbereich (5, 6) unabhängig voneinander durch eine Ansteuereinrichtung (12) angesteuert sind.

5. Organische Leuchtdiodenvorrichtung nach einem der Ansprüche 1 bis 3, wobei der erste und der zweite Leuchtbereich (5, 6) in Serie oder parallel von einer Ansteuereinrichtung (12) angesteuert sind.

6. Organische Leuchtdiodenvorrichtung nach einem der vorhergehenden Ansprüche einschließlich Anspruch 2, wobei sowohl eine erste Grenzlinie zwischen dem ersten Leuchtbereich (5) und dem ersten Biegebereich (1) als auch eine zweite Grenzlinie zwischen dem zweiten Leuchtbereich (6) und dem ersten Biegebereich (1) parallel zur Biegeachse (1a) verlaufen.

7. Organische Leuchtdiodenvorrichtung nach einem der vorhergehenden Ansprüche, wobei die beiden Leuchtbereiche (5, 6) unterschiedliche Leuchtfarben besitzen.

8. Organische Leuchtdiodenvorrichtung nach einem der vorhergehenden Ansprüche, wobei der erste Leuchtbereich mehrere Emitterschichten übereinander aufweist, die jeweils entweder die gleiche Farbe oder auch unterschiedliche Farben abstrahlen.

9. Kraftfahrzeug (10), bei dem ein Schlusslicht, ein Bremslicht und ein Blinklicht mit einer organischen Leuchtdiodenvorrichtung nach einem der vorhergehenden Ansprüche als einzelnes Bauelement realisiert ist.

## Claims

1. An organic light-emitting diode device comprising
- a bendable substrate,
- an organic light-emitting diode layer arrangement, which comprises an organic emitter layer, which is formed on the bendable substrate and which comprises a first lighting area (5, 6), and
- a control device for controlling the first lighting area (5) for lighting, wherein
- the substrate comprises a first bending area (1), in which the substrate is bent,
**characterized in that**
- the first bending area (1) is not controllable for lighting by the control device,
- the organic emitter layer is not formed at least in a part of the first bending area (1), but comprises an anode layer and/or a cathode layer and/or a charge carrier conductor layer,
and
- the substrate is bent by a torsion in the first bending area (1), or
- a bending radius changes along a bending line within the first bending area.

2. The organic light-emitting diode device according to claim 1, wherein a bending axis (1a) is defined, around which the entire first bending area (1) is bent.

3. The organic light-emitting diode device according to any one of the preceding claims, wherein the organic light-emitting diode layer arrangement comprises a second lighting area (6), and the first bending area (1) connects the first lighting area (5) to the second lighting area (6), and wherein a second bending area (2) optionally adjoins to the second lighting area (6) and thereto a third lighting area (7).

4. The organic light-emitting diode device according to any one of the preceding claims, wherein the first and the second lighting area (5, 6) are controlled independently of each other by a control device (12).

5. The organic light-emitting diode device according to any one of claims 1 to 3, wherein the first and the second lighting area (5, 6) are controlled in series or parallel by a control device (12).

6. The organic light-emitting diode device according to any one of the preceding claims including claim 2, wherein both a first boundary line between the first lighting area (5) and the first bending area (1) and a second boundary line between the second lighting area (6) and the first bending area (1) extend parallel to the bending axis (1a).

7. The organic light-emitting diode device according to any one of the preceding claims, wherein the two lighting areas (5, 6) have different lighting colors.

8. The organic light-emitting diode device according to any one of the preceding claims, wherein the first lighting area comprises multiple emitter layers on top of each other, which each radiate either the same color or also different colors.

9. A motor vehicle (10), in which a tail light, a brake light and a blinking light are realized with an organic light-emitting diode device according to any one of the preceding claims as a single component.

## Revendications

1. Dispositif à diodes électroluminescentes organiques comportant :
- un substrat pliable,
- un agencement de couches de diodes électroluminescentes organiques comportant une couche émettrice organique formée sur le substrat pliable et comportant une première zone d'éclairage (5, 6), et
un dispositif de commande pour commander la première zone d'éclairage (5) à éclairer,
- le substrat comportant une première zone de pliage (1) dans laquelle le substrat est plié,
**caractérisé en ce que**
- la première zone de pliage (1) à ne pas éclairer peut être commandée par le dispositif de commande,
- la couche émettrice organique n'est pas formée au moins dans une partie de la première zone de pliage (1), mais elle comporte une couche d'anode et/ou une couche de cathode et/ou une couche conductrice de porteur de charges,
et
- le substrat est plié par une torsion dans la première zone de pliage (1), ou
- un rayon de pliage à l'intérieur de la première zone de pliage change le long d'une ligne de pliage.

2. Dispositif à diodes électroluminescentes organiques selon la revendication 1, dans lequel est défini un axe de pliage (1a) autour duquel toute la première zone de pliage (1) est pliée.

3. Dispositif à diodes électroluminescentes organiques selon l'une des revendications précédentes, dans lequel l'agencement de couches de diodes électroluminescentes organiques comporte une deuxième zone d'éclairage (6), et la première zone de pliage (1) relie la première zone d'éclairage (5) à la deuxième zone d'éclairage (6), et une seconde zone de pliage (2) étant facultativement adjacente à la deuxième zone d'éclairage (6) et une troisième zone d'éclairage (7) étant adjacente à celle-ci.

4. Dispositif à diodes électroluminescentes organiques selon l'une des revendications précédentes, dans lequel les première et seconde zones d'éclairage (5, 6) sont commandées indépendamment l'une de l'autre par un dispositif de commande (12).

5. Dispositif à diodes électroluminescentes organiques selon l'une des revendications 1 à 3, dans lequel les première et seconde zones d'éclairage (5, 6) sont commandées en série ou en parallèle par un dispositif de commande (12).

6. Dispositif à diodes électroluminescentes organiques selon l'une des revendications précédentes, revendication 2 incluse, dans lequel aussi bien une première ligne de frontière entre la première zone d'éclairage (5) et la première zone de pliage (1) qu'une seconde ligne de frontière entre la deuxième zone d'éclairage (6) et la première zone de pliage (1) s'étendent parallèlement à l'axe de pliage (1a).

7. Dispositif à diodes électroluminescentes organiques selon l'une des revendications précédentes, dans lequel les deux zones d'éclairage (5, 6) ont différentes couleurs d'éclairage.

8. Dispositif à diodes électroluminescentes organiques selon l'une des revendications précédentes, dans lequel la première zone d'éclairage a plusieurs couches émettrices les unes au-dessus des autres, qui émettent respectivement soit la même couleur, soit différentes couleurs.

9. Véhicule à moteur (10), dans lequel un feu de stop, un feu de frein et un feu clignotant sont réalisés sous forme de composant individuel avec un dispositif à diodes électroluminescentes organiques selon l'une des revendications précédentes.
